Europäisches Patentamt

**European Patent Office**

**Office européen des brevets**

(11) Numéro de publication: **0 232 662 B1**

# (12) FASCICULE DE BREVET EUROPEEN

(45) Date de publication de fascicule du brevet: **15.07.92** (51) Int. Cl.⁵: **H01L 27/15**, H01S 3/19

(21) Numéro de dépôt: **86402973.1**

(22) Date de dépôt: **31.12.86**

(54) Structure semi-conductrice monolithique d'un laser et d'un transistor à effet de champ et son procédé de fabrication.

(30) Priorité: **06.01.86 FR 8600089**

(43) Date de publication de la demande:
**19.08.87 Bulletin 87/34**

(45) Mention de la délivrance du brevet:
**15.07.92 Bulletin 92/29**

(84) Etats contractants désignés:
**DE GB NL**

(56) Documents cités:
**EP-A- 0 080 714**
**EP-A- 0 166 593**
**US-A- 4 366 567**

**JAPANESE JOURNAL OF APPLIED PHYSICS, vol. 18, 1979, supplément 18-1, pages 371-375, Proceedings of the 10th conference on solid state devices, Tokyo, 1978, JP; H. KUMABE et al.: "High temperature single mode CW operation with a TJS laser using a semi-insulating GaAs substrate"**

(73) Titulaire: **Brillouet, François**
**34 bis rue des Fontaines**
**F-92310 Sèvres(FR)**

Titulaire: **Rao, Krishna**
**1, rue du Moulin de Pierre**
**F-92130 Issy-Les-Moulineaux(FR)**

Titulaire: **Alexandre, François**
**11, rue des Recollets**
**F-75010 Paris(FR)**

(72) Inventeur: **Brillouet, François**
**34 Bis rue des Fontaines**
**F-92310 Sevres(FR)**
Inventeur: **Rao, Krishna**
**1, rue du Moulin de Pierre**
**F-92130 Issy-Les-Moulineaux(FR)**
Inventeur: **Alexandre, François**
**11, rue des Recollets**
**F-75010 Paris(FR)**

(74) Mandataire: **Mongrédien, André et al**
**c/o BREVATOME 25, rue de Ponthieu**
**F-75008 Paris(FR)**

Rank Xerox (UK) Business Services

**IEEE ELECTRON DEVICE LETTERS, vol. EDL-2, no. 1, janvier 1981, pages 14-15, IEEE, New York, US; S. JUDAPRAWIRA et al.: "Modulation-doped MBE GaAs/n-AlxGa1-xAs MESFETs"**

**APPLIED PHYSICS LETTERS, vol. 36, no. 3, 1er février 1980, pages 181-183, American Institute of Physics, New York, US; T. FUKU-ZAWA et al.: "Monolithic integration of a GaA1As injection laser with a schottky-gate field effect transistor"**

## Description

La présente invention a pour objet une structure plane semi-conductrice monolithique d'un laser et d'un transistor à effet de champ, ce transistor faisant partie du circuit de commande ou de modulation du laser. Elle a aussi pour objet un procédé de fabrication de cette structure.

La source laser et son circuit de commande intégré de l'invention est utilisable principalement dans le domaine de la télémétrie, de l'optique intégrée ou des télécommunications par fibre optique.

De façon plus précise, l'invention se rapporte à une structure laser-transistor à effet de champ intégrée, plane, réalisée sur un substrat semi-isolant en matériau III-V.

Dans la plupart des solutions d'intégration d'une source laser et d'un transistor à effet de champ connues, la couche semi-conductrice constituant le canal du transistor et la couche semi-conductrice dans laquelle sont formés les contacts électriques du transistor, réalisés par épitaxie ou par implantation, s'ajoutent à la croissance des couches semi-conductrices du laser.

Comme solutions d'intégration connues, on peut citer celle décrite dans l'article de Appl. Phys. Lett. 41 (2), du 15 juillet 1982, pp. 126-128, intitulé "Very high frequency GaAlAs laser field-effect transistor monolithic integrated circuit" de I. URY et K.Y. LAU et celle décrite dans l'article Appl. Phys. Lett. 46 (3), de février 1985, pp. 226-228, intitulé "Monolithic Integration of a low threshold current quantum well laser and a driver circuit on a GaAs substrate" de T. SANADA et al. Dans ces deux solutions d'intégration, le laser et le transistor sont juxtaposés sur le même substrat semi-isolant en GaAs. Par ailleurs, le plan de la jonction laser PN est celui des couches semi-conductrices épitaxiées à partir du substrat. Le laser est dit à injection verticale des électrons.

Actuellement, la technique utilisant une structure laser à injection verticale des électrons est la seule permettant d'obtenir un laser à hétérojonction. Les avantages d'une telle structure laser sont notamment un faible courant de seuil, et donc une faible dissipation thermique, ainsi qu'un fort rendement différentiel, et donc une nécessité d'un faible courant de modulation. En outre, les structures laser-transistor à effet de champ correspondantes présentent une faible sensibilité thermique ; elles peuvent fonctionner à température élevée.

Les performances de ces structures laser-transistor à effet de champ intégrée, sont donc proches de celles des composants discrets. Cependant, pour la réalisation d'un transistor à grille courte (de largeur au plus égale à 1 μm) et donc d'un transistor à transconductance élevée, il est nécessaire de former le laser au fond d'un trou, lorsque ledit laser est disposé à côté du transistor. A cet effet, on peut se référer à l'article ci-dessus de T. SANADA et al.

Malheureusement, cette technologie est relativement délicate et pose notamment des problèmes en ce qui concerne la réalisation du masque de résine, selon la technique de photolithographie, servant à définir les dimensions de la grille du transistor. Cette technologie est difficilement reproductible. En outre, pour augmenter la fiabilité de réalisation du transistor, les couches semi-conductrices de ce composant doivent être réalisées après l'épitaxie des couches semi-conductrices du laser, lors d'épitaxies supplémentaires ou d'implantations ioniques.

La formation de la jonction PN d'un laser, par diffusion de dopants dans les couches épitaxiées de la structure laser, est notamment décrite dans un article de GaAs IC Symposium de 1982 intitulé "Monolithic optoelectronic/électronic circuits" de J.K CARNEY et al. pages 38 à 41.

Une autre structure semi-conductrice comportant un laser et un transistor à effet de champ intégré sur le même substrat III-V est décrite dans le document Applied Physics Letters, vol. 36, n° 3, 1er février 1980, pages 181-183, American Institute of Physics, New York, USA ; T. Fukuzawa et ai. : "Monolithic integration of a GaAlAs injection laser with a schottky-gate field effect transistor".

On connaît aussi des structures laser seules sur GaAs, dans lesquelles le plan d'injection des électrons est perpendiculaire au plan des couches semi-conductrices épitaxiées, la jonction PN du laser étant définie par diffusion de dopants dans ces couches semi-conductrices. Une telle structure, dite à injection transverse, (TJS en abrégé), a notamment été décrite dans Jap. Jour. of Appl. Phys. Vol. 18 (1979) supplément 18-1, pp. 371-375, intitulé "High temperature single mode CW operation with a TJS laser using a semi-insulating GaAs substrate" de H. KUMABE et al.

Malheureusement, cette structure laser présente l'inconvénient d'un contact, sur la région P du laser, isolé au sommet d'un mésa. Par ailleurs, cette structure est une structure à homojonction, c'est-à-dire à courant de seuil sensiblement plus élevé que ceux des structures lasers à hétérojonction et à rendement différentiel inférieur à ceux des structures à hétérojonction (25% au lieu de 35% par face). En outre, cette structure à injection transverse présente une température critique de fonctionnement au-delà de laquelle le courant de seuil augmente très rapidement ; ceci est dû à une conduction parallèle des couches de confinement du taser jouxtant la couche active de celui-ci.

En revanche, les fréquences de modulation de ce laser ainsi que la bande passante en fréquence sont très élevées compte tenu des faibles capacités parasites et des faibles résistances de contact sur la région P réparties sur une grande surface.

L'invention a justement pour objet une structure semi-conductrice monolithique d'un laser et d'un transistor à effet de champ ainsi que son procédé de fabrication permettant de remédier aux différents inconvénients donnés ci-dessus. En particulier, elle permet une véritable intégration du laser et du transistor à effet de champ selon une structure entièrement plane et à partir d'une seule épitaxie du substrat semi-isolant.

De façon plus précise, l'invention a pour objet une structure semi-conductrice monolithique telle que définie dans la revendication 1, réalisée sur un substrat semi-isolant monocristallin, comportant une première, une seconde et une troisième couche semi-conductrices superposées dans cet ordre sur un substrat semi-isolant monocristallin ; la première et la troisième couches étant non dopées, la seconde couche présentant une bande interdite inférieure aux bandes interdites de la première et de la troisième couches et constituant la couche active du laser et le canal du transistor.

Dans la suite de la description, la seconde couche semi-conductrice sera aussi appelée couche active.

La structure selon l'invention est beaucoup plus simple que celle de l'art antérieur.

De façon avantageuse, le laser comprend deux électrodes métalliques situées dans un plan parallèle aux couches semi-conductrices, la source et le drain du transistor étant pourvus de contacts ohmiques situés dans ce plan.

Afin de minimiser la résistance de contact entre les couches semi-conductrices et les électrodes d'une part et d'autre part les contacts ohmiques, la structure semi-conductrice selon l'invention comporte avantageusement sur la troisième couche semi-conductrice une quatrième couche semi-conductrice présentant une bande interdite inférieure à celle des première et troisième couches.

La structure semi-conductrice seton l'invention est réalisée sur un substrat monocristallin en matériau III-Y qui peut être de l'InP, du GaAs, du GaSb, du InAs ou du InSb.

Dans le cas d'un substrat en GaAs, la première, la seconde et la troisième couches semi-conductrices sont réalisées respectivement en $Ga_{1-x}Al_xAs$ non dopé, $Ga_{1-y}Al_yAs$ dopé N et $Ga_{1-z}Al_zAs$ non dopé, avec $0 < x \leq 1$, $0 \leq y < 1$ et $0 < z \leq 1$, x et z étant supérieurs à y. En outre, la quatrième couche semi-conductrice est réalisée en GaAs non dopé.

Avec une telle structure, on obtient une source laser émettant notamment à une longueur d'onde de 0,85 $\mu$. Cette structure peut alors être utilisée dans le domaine des télécommunications à courte distance.

Par couche ou matériau non dopé, il faut comprendre des couches ou des matériaux non intentionnellement dopés. Les impuretés résiduelles de ces couches ou matériaux, de l'ordre de $10^{15}$ à $10^{16}$ atomes/cm³, sont de type N ou P. Elles sont inhérentes aux procédés d'épitaxie des couches et des produits de départ qui ne sont pas à 100% purs.

Dans le cas d'un substrat en InP, la première, la seconde, la troisième et la quatrième couches semi-conductrices peuvent être réalisées respectivement en InP non dopé, en $In_tGa_{1-t}As_{t'}P_{1-t'}$ dopé N, avec $0 \leq t < 1$ $0 < t' < 1$, en InP non dopé et en InP ou $In_sGa_{1-s}As$ non dopé, avec $0 < s < 1$. Avec une telle structure, on obtient une source laser émettant une longueur d'onde de 1,3 ou 1,55 $\mu m$ suivant les valeurs de t et $t'$. Cette structure peut être utilisée dans les télécommunications pour les transmissions à longue distance.

Selon un mode préféré de réalisation de l'invention, la structure comprend, sur un substrat en GaAs :

- une première couche semi-conductrice en $Ga_{1-x}Al_xAs$ non dopé, avec $0,2 \leq x \leq 0,7$, recouverte d'une seconde couche semi-conductrice en $Ga_{1-y}Al_yAs$ dopé N avec $0 \leq y \leq 0,15$, formant la couche active du laser et le canal du transistor,
- une troisième couche semi-conductrice en $Ga_{1-z}Al_zAS$ non dopé, avec $0,2 \leq z \leq 0,7$ recouvrant la seconde couche,
- une quatrième couche semi-conductrice en GaAs non dopé recouvrant la troisième couche,
- une première région de type P, une seconde et une troisième régions de type N, formées dans les première, seconde, troisième et quatrième couches et orientées perpendiculairement à ces couches, la première et la seconde régions délimitant entre elles la zone active du laser, la seconde et la troisième régions, formant respectivement le drain et la source du transistor, délimitant entre elles le canal du transistor,
- une électrode en Au-Zn recouvrant la région de type P,
- un contact ohmique en AuGeNi recouvrant chacune des régions de type N, et
- une grille en TiPtAu surmontant le canal du transistor.

Cette structure se différencie notamment des structures connues par le fait que les première, troisième et quatrième couches semi-conductrices sont non dopées. Dans ce cas, les rapports $R_3/R_2$ et $R_1/R_2$, $R_1$, $R_2$ et $R_3$ représentant respectivement les résistances des première, troisième et quatrième couches, sont supérieurs d'au moins un facteur 10 par rapport à ceux des couches de l'art antérieur (article ci-dessus de KUMABE). Ceci permet un fonctionnement à plus haute température. Par ailleurs, les capacités parasites de cette structure sont plus faibles que celles des structures antérieures, ce qui permet un fonctionnement dans une bande passante en fréquence plus élevée.

Afin que l'intensité de lumière délivrée par la source laser soit élevée et que le courant de seuil de cette source soit faible, on réalisera de préférence la couche active semi-conductrice de la Structure intégrée sous forme d'un super-réseau constitué de deux séries de couches minces semi-conductrices de composition différente, c'est-à-dire de valeur de y différente, alternées. Cette technique, décrite dans l'article de SANADA, ci-dessus et appelée en terminologie anglosaxonne "multi-quantum well" (MQW) permet de plus l'utilisation de courants plus faibles de modulation du laser, suite à un rendement différentiel plus élevé. En outre, elle permet d'obtenir un transistor à effet de champ à fonctionnement plus rapide que celui du transistor classique par opposition au transistor quantique.

De plus, la Structure intégrée correspondante présente une sensibilité thermique (To) encore plus faible.

Dans une autre variante, la couche active semi-conductrice de la Structure est une couche dont la composition y varie progressivement dans l'épaisseur de la couche. Cette technique (décrite aussi dans l'article de SANADA) est généralement connue en terminologie anglosaxonne sous le nom de GRINSCH (graded index separate confinement heterostructrue).

Afin que le confinement de la lumière soit maximum, la couche active semi-conductrice présentera une épaisseur relativement faible. Lorsque cette couche a une structure classique (y constant), l'épaisseur varie de 50 nm à 500 nm. Pour une couche quantique (y variable), l'épaisseur varie de 10 nm à 50 nm.

Dans le but d'abaisser la tension de seuil du transistor à effet de champ, la grille de celui-ci sera avantageusement située à un niveau inférieur à celui des contacts ohmiques de la source et du drain.

L'invention a aussi pour objet un procédé de fabrication d'une structure semi-conductrice monolithique d'un laser et d'un transistor à effet de champ tels que décrits précédemment.

Selon l'invention, ce procédé se caractérise en ce qu'il consiste à :
- épitaxier sur le substrat, dans l'ordre, une première, une seconde et une troisième couches semi-conductrices, la première et la troisième couches étant non dopées, la seconde couche présentant une bande interdite inférieure aux bandes interdites de la première

re et de la troisième couches, constituant la couche active du laser et le canal du transistor,
- introduire des ions dans les couches semi-conductrices pour former une première région d'un premier type de conductivité, une seconde et une troisième régions d'un second type de conductivité, orientées perpendiculairement aux plans des couches semi-conductrices, la première et la seconde régions délimitant entre elles la zone active du laser, la seconde et la troisième régions formant respectivement le drain et la source du transistor, délimitant entre elles le canal du transistor, et
- former les électrodes du laser, le contacts ohmiques de la source et du drain du transistor ainsi que la grille du transistor.

Ce procédé est facile à mettre en oeuvre et toutes les étapes de ce procédé sont non critiques ; il est reproductible.

D'autres caractéristiques et avantages de l'invention ressortiront mieux de la description qui va suivre, donnée à titre explicatif et non limitatif en référence aux figures annexées, dans lesquelles :
- les figures 1 à 11 illustrent les différentes étapes de fabrication d'une structure semi-conductrice selon l'invention, les figures 1 à 10 étant des vues en coupe longitudinale et la figure 11 une vue en perspective,
- la figure 12 représente une variante de réalisation du transistor à effet de champ de la structure selon l'invention,
- la figure 13 est une courbe donnant les variations de la composition y de la couche active de la structure selon l'invention en fonction de la profondeur p de cette couche, selon une première variante, et
- la figure 14 est une courbe donnant les variations de la composition y de la couche active de la structure selon l'invention en fonction de la profondeur de cette couche, selon une seconde variante.

La description ci-après se réfère à une structure selon l'invention en AlGaAs/GaAs à structure plane, ce type de matériau étant le plus communément utilisé. Toutefois, l'invention s'applique à d'autres structures III-V et en particulier à des structures en InGaAsP/InP ou GaAsP/GaAs.

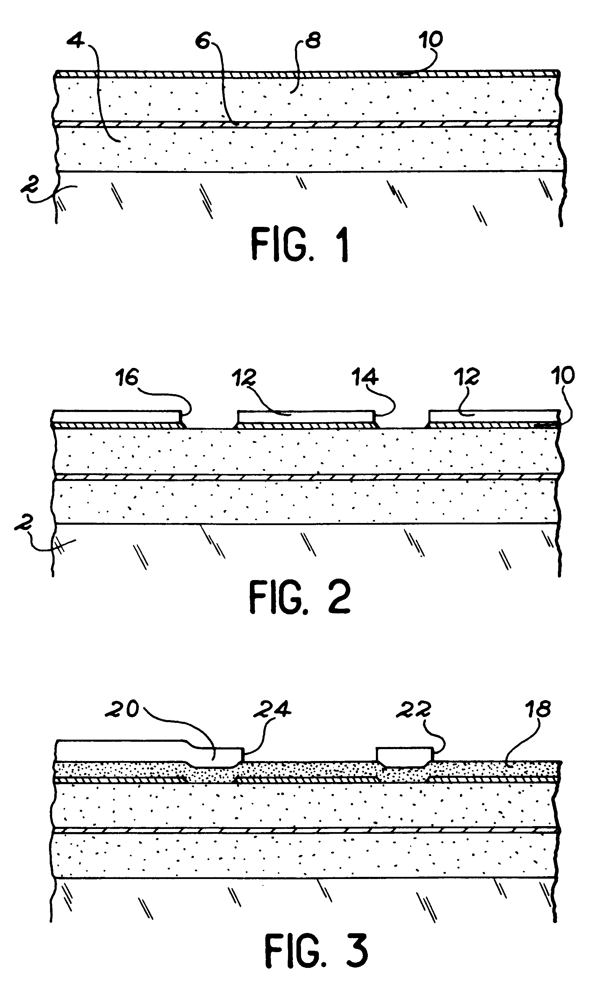

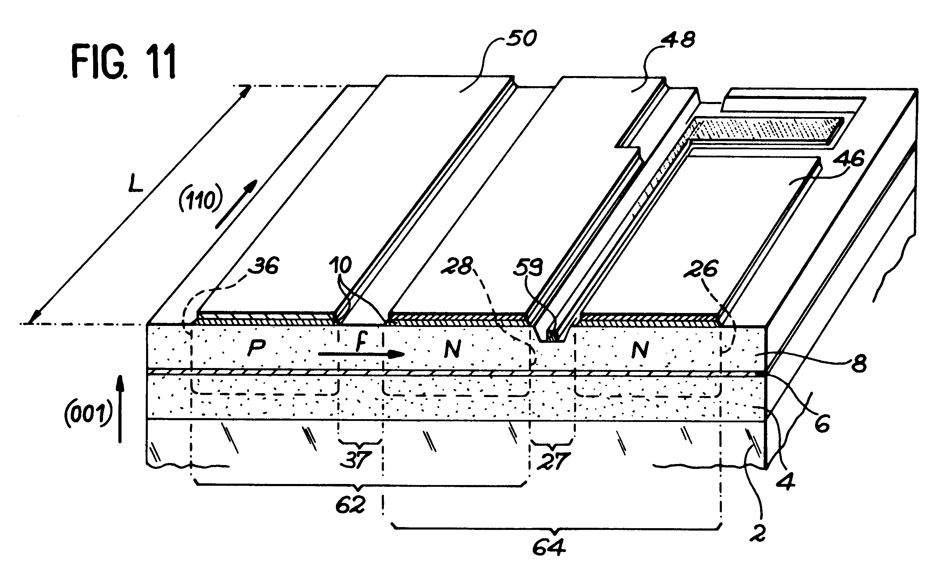

La structure monolithique selon l'invention est formée, comme représenté sur les figures 1 à 11, sur un substrat 2 en GaAs monocristallin et semi-isolant, obtenu par clivage, présentant une largeur L (figure 11) par exemple de 300 $\mu$m, une longueur de 1000 $\mu$m et une épaisseur de 300 $\mu$m. Ce substrat 2 comporte par exemple une orientation cristallographique (001) selon son épaisseur et une orientation (110) selon sa largeur.

Sur le substrat 2, on forme par épitaxie, comme représenté sur la figure 1, quatre couches semi-conductrices, l'une au-dessus de l'autre qui, en partant du substrat, portent les références 4, 6, 8 et 10. La couche 4 est réalisée en $Ga_{1-x}Al_xAs$, non intentionnellement dopé avec $0 < x \leq 1$ et, par exemple $0,2 \leq x \leq 0,7$. Cette couche semi-conductrice 4 présente une épaisseur d'environ 0,5 $\mu$m.

La seconde couche semi-conductrice 6, qui formera la couche active du laser et le canal du transistor à effet de champ, est réalisée en $Ga_{1-y}Al_yAs$ dopé N avec $0 \leq y < 1$. En particulier, y est tel que $0 \leq y \leq 0,15$. Le dopage N de cette couche 6 semi-conductrice peut être réalisé avec du silicium ou de l'étain à une concentration de quelques $10^{17}$ atomes/cm$^3$. Cette couche 6 présente une épaisseur d'environ 0,15 $\mu$m.

La troisième couche semi-conductrice 8 est réalisée en $Ga_{1-z}Al_zAs$, non intentionnellement dopé, avec $0 < z \leq 1$. En particulier, z est tel que $0,2 \leq z \leq 0,7$. Cette couche semi-conductrice doit présenter une épaisseur reduite au maximum pour permettre les diffusions ou implantations ioniques successives dans la couche active 6. Une épaisseur d'environ 0,5 $\mu$m est bien adaptée.

La quatrième couche semi-conductrice est réalisée en GaAs, non intentionnellement dopé Elle présente une épaisseur d'environ 0,1 $\mu$m.

Ces quatre couches semi-conductrices 4, 6, 8, 10 sont réalisées avantageusement par épitaxie chimique en phase vapeur à partir de composés organo-métalliques, connue sous l'abréviation MOCVD (Metal Organic Chemical Vapor Deposition) ou par épitaxie par jet moléculaire, connue sous l'abréviation MBE (Molecular Beam Epitaxy).

Les couches 6 et 10 contenant une composition en aluminium inférieure à celle des couches 4 et 8, présentent une bande interdite inférieure à celle des couches 4 et 8 et constituent respectivement la couche active de la structure semi-conductrice intégré et la couche de contact électrique pour le laser et le transistor effet de champ. Les couches semi-conductrices 4 et 8 constituent les couches de confinement des électrons et donc de la lumière produite dans la zone active du laser.

Une composition typique des quatre couches semi-conductrices épitaxiées sur le substrat isolant est :
- couche 4 en $Al_{0,6}Ga_{0,4}As$,
- couche 6 en $Al_{0,08}Ga_{0,92}As$ dopé avec du silicium à une concentration de $5.10^{17}$ atomes/cm$^3$,
- couche 8 en $Al_{0,6}Ga_{0,4}As$, et
- couche 10 en GaAs.

Après le dépôt des quatre couches semi-conductrices, on forme la jonction PN du laser, la source et le drain du transistor à effet de champ par diffusion ou implantation d'ions dans les quatre couches semi-conductrices. Pour former la jonction PN du laser, on utilise des ions de deux types de conductivités différentes N et P et pour former la source et le drain du transistor, on utilise soit des ions de type N, soit des ions de type P.

A cet effet, on réalise tout d'abord, par les procédés classiques de photolithographie, un masque de résine 12 comportant deux ouvertures 14 et 16, comme représenté sur la figure 2. Ces ouvertures 14 et 16 définissent respectivement les dimensions de la zone active ou canal du transistor à effet de champ et les dimensions de la zone active du laser. La résine utilisée est par exemple une résine positive à base de phénol-formaldéhyde, commercialisée sous la référence AZ 1350 H de chez Shippley. Les ouvertures 14 et 16 pratiquées dans cette résine ont une largeur allant de 3 à 5 $\mu$m et une longueur égale à la largeur L du substrat 2.

A l'aide du masque de résine 12, on réalise une gravure de la couche semi-conductrice 10 consistant à éliminer des zones de cette couche non recouvertes de résine. Cette gravure peut être réalisée par une attaque chimique sélective, c'est-à-dire n'attaquant que la couche 10. Comme agent d'attaque, on peut utiliser un mélange de $NH_4OH$, $H_2O_2$ et $H_2O$ avec des quantités en volume de 1/7/16. On élimine ensuite le masque de résine 12 par dissolution chimique par exemple avec de l'acétone.

L'étape suivante du procédé consiste, comme représenté sur la figure 3, à déposer une couche d'isolant 18 sur l'ensemble de la structure. Cette couche d'isolant 18, présentant une épaisseur de 200 nm environ, peut être réalisée en oxyde de silicium ($SiO_2$) ou en nitrure de silicium ($Si_3N_4$). Cette couche d'isolant 18 peut être déposée par un procédé de dépôt chimique en phase vapeur (CVD). La température de dépôt pour une couche en $Si_3N_4$ est de l'ordre de 400°C et pour une couche de $SiO_2$ de 400 °C.

On réalise ensuite, sur la couche d'isolant 18 un masque de résine 20, par exemple un masque de résine positive de même composition que le masque 12 précédent. Ce masque 20 comporte des ouvertures 22 et 24 dont les dimensions sont celles de la source et du drain du transistor à effet de champ à réaliser. La largeur de ces ouvertures est de l'ordre de 200 $\mu$m.

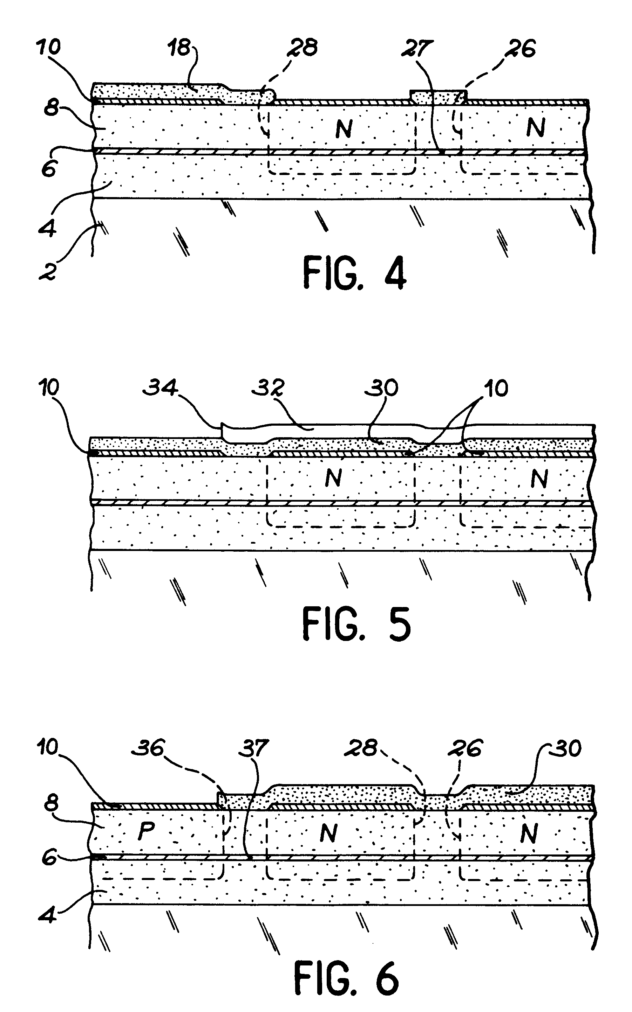

A travers ce masque de résine 20, on réalise ensuite, comme représenté sur la figure 4, une gravure de la couche d'isolant 18 consistant à éliminer les zones de cette couche non recouvertes de résine 20. Dans le cas d'une couche 18 en $Si_3N_4$, cette gravure peut être réalisée par un procédé ionique réactif utilisant un plasma de $CF_4$ contenant 8% de $O_2$.

On réalise ensuite une implantation ou une diffusion d'ions dans les quatre couches semi-conductrices 4, 6, 8 et 10 et perpendiculairement à ces couches, pour former la source 26 et le drain 28 du transistor, la couche d'isolant 18 gravée servant de masque à cette diffusion ou implantation d'ions. Les régions 26 et 28 diffusées ou implantées, délimitent entre elles la zone active 27 du canal du transistor, cette zone 27 étant située dans la couche active 6 de la structure. La largeur de cette zone active est égale à la largeur L du substrat.

La formation d'une source et d'un drain de type N est réalisée à l'aide d'une diffusion ou d'une implantation d'ions de soufre ou d'étain. Dans le cas particulier d'une diffusion de soufre, celle-ci peut être réalisée dans un creuset semi-fermé, à pression atmosphérique et sous un balayage de gaz contenant 15% de $H_2$ et 85% de Ar, à 850°C, pendant 4 heures. Cette technique de diffusion permet d'obtenir des couches N d'environ 0,9 $\mu$m contenant $5.10^{17}$ à $2.10^{18}$ atomes/cm$^3$ de soufre.

Lorsque la source et le drain du transistor sont réalisés par implantation ionique, cette dernière peut être effectuée sans utiliser de couche d'isolant 18 gravée comme masque d'implantation et en utilisant alors la résine 20 comme masque d'implantation. La profondeur d'implantation des ions est liée à l'énergie du faisceau d'ions.

Après formation de la source 26 et du drain 28 du transistor à effet de champ, en utilisant comme masque la couche d'isolant 18 gravée, on élimine cette couche d'isolant au moyen d'un plasma réactif de $CF_4$ contenant 8% d'$O_2$, pour une couche en $Si_3N_4$.

Sur la structure obtenue, on dépose alors, comme représenté sur la figure 5, une nouvelle couche d'isolant 30 de 200 nm en oxyde de silicium ou en nitrure de silicium. Le dépôt est réalisé dans les mêmes conditions que pour la couche 18.

Sur cette couche d'isolant 30, on forme un masque de résine notamment positive 32, par les procédés classiques de photolithographie comportant une ouverture 34. Cette ouverture 34 présentant une largeur d'environ 200 $\mu$m, permet de définir les dimensions de la région P de la jonction PN du laser, la région N 28 constituant l'autre partie de ladite jonction PN.

On effectue alors l'élimination des zones de la couche d'isolant 30 non recouvertes de résine 32, dans les mêmes conditions que précédemment, par attaque plasma avec du $CF_4$ et 8% d'$O_2$ pour une couche 30 en $Si_3N_4$. Ensuite, on élimine par voie chimique le masque de résine 32.

Comme représenté sur la figure 6, on effectue alors la diffusion ou l'implantation d'ions de type P dans les quatre couches semi-conductrices 4, 6, 8, 10 pour former la région P 36 du laser. Les régions N 28 et P 36, diffusées ou implantées, délimitent entre elles la zone active 37 du laser, cette zone 37 étant située dans la couche active 6 de la structure. La longueur de la zone active du laser est égale à la largeur L du substrat.

Les ions utilisés peuvent être des ions de zinc ou de béryllium. Dans le cas d'une diffusion de zinc, celle-ci peut être réalisée à la pression atmosphérique, dans un creuset semi-fermé, à une température de l'ordre de 650°C, pendant 2 heures. Cette technique de diffusion permet d'obtenir une région P 36 d'environ 0,9 $\mu$m contenant de $5.10^{17}$ à $10^{19}$ atomes/cm$^3$.

Lorsque cette région P est formée par implantation ionique, cette dernière peut être réalisée en utilisant le masque de résine 32 comme masque d'implantation.

Pour éviter que la diffusion des ions de zinc ou de béryllium ne se poursuive, lors de la formation des régions de type N par diffusion, il est préférable de réaliser la diffusion de type P en second ; en effet, la diffusion P est réalisée à une température nettement plus basse que celle nécessaire pour la diffusion de type N.

Comme on l'a dit précédemment, il est possible d'utiliser à la place d'un transistor à effet de champ de type N un transistor à effet de champ de type P. Dans ce cas, les régions 26 et 28 seraient de type P et la région 36 de type N.

Après formation de la région de type P 36 en utilisant la couche d'isolant 30 comme masque à cette diffusion, on élimine cette couche 30 par exemple avec un plasma réactif de $CF_4$ et de 8% d'$O_2$ pour une couche en $Si_3N_4$.

Les étapes suivantes consistent à réaliser l'électrode du laser et les contacts ohmiques de la source et du drain du transistor à effet de champ.

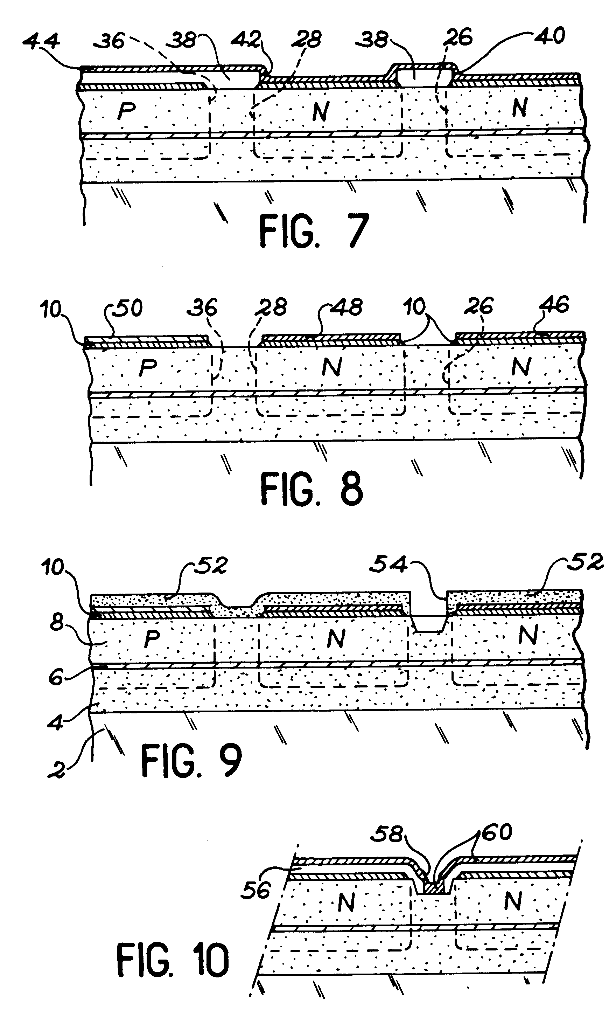

On réalise tout d'abord, comme représenté sur la figure 7, les contacts ohmiques de la source 26 et du drain 28 du transistor en formant sur la structure un masque de résine 38, comportant des ouvertures 40, 42 définissant les dimensions des contacts ohmiques réciproquement de la source et du drain du transistor. Ces fenêtres 40 et 42 sont situées juste en regard des régions N et présentent les mêmes dimensions que ces régions.

On réalise ensuite sur la couche de résine 38 un dépôt métallique 44 d'environ 50 nm. Ce dépôt 44 est par exemple formé d'au moins deux couches métalliques superposées susceptibles de former par alliage une unique couche métallique. En particulier, ce dépôt peut être formé d'une couche de nickel, d'une couche de germanium et d'une couche d'or pour former des contacts ohmiques en AuGeNi.

On dissout ensuite par exemple dans de l'acétone la couche de résine 38 emportant avec elle les parties du dépôt métallique 44 situées au-dessus d'elle. Cette technique de dépôt sélectif est connue en terminologie anglosaxonne sous le nom de "lift-off". La structure obtenue est représentée sur la figure 8. Les contacts ohmiques réciproquement de la source 26 et du drain 28 du transistor portent les références 46 et 48.

Par cette même technique de "lift-off" on forme sur la région P 36 du laser une électrode 50, présentant par exemple une épaisseur de 50 nm. Cette électrode 50 est notamment réalisée en AuZn, ce matériau étant obtenu par alliage d'une couche d'or et d'une couche de zinc superposée.

Il est à noter qu'on aurait pu effectuer ce dépôt métallique 50 avant de réaliser le dépôt métallique 44. Par ailleurs, le contact ohmique 48 du drain du transistor constitue aussi l'électrode de la région N de la jonction PN du laser.

Après formation des dépôts métalliques du laser et du transistor, on effectue un recuit pendant environ 30 min. à une température de 560°C afin de transformer les dépôts conducteurs en des contacts ohmiques, par alliage.

Le fait de réaliser le laser et le transistor à effet de champ par diffusion ou implantation d'ions dans les mêmes couches semi-conductrices épitaxiées sur un même substrat, et en particulier de former le canal du transistor et la couche active du laser dans la même couche semi-conductrice 4 et de former les contacts ohmiques de la source et du drain du transistor et du laser dans la même couche semi-conductrice 10, permet d'obtenir une structure plane. En effet, l'électrode 50 du laser et les contacts ohmiques 46, 48 de la source et du drain du transistor sont coplanaires. Cette structure plane va permettre de réaliser sans aucune difficulté une grille courte, par exemple de l'ordre de 1 $\mu$m, pour le transistor à effet de champ.

Les étapes suivantes du procédé sont relatives à la fabrication d'une grille courte enterrée. L'utilisation d'une grille enterrée, lorsque l'épaisseur de la couche semi-conductrice 8 l'autorise, permet de diminuer la tension de seuil du transistor.

Après le recuit à 560°C o réalise, comme représenté sur la figure 9, sur la structure, un masque de résine 52 notamment en résine positive, comportant une ouverture 54 située au-dessus et en regard de la zone active 37 du transistor à effet de champ. La largeur de cette ouverture est légèrement inférieure à celle de la zone active.

A travers ce masque 52, obtenu selon les procédés classiques de photolithographie, on réalise une gravure, sur une hauteur d'environ 0,4 $\mu$m, de la région de la couche semi-conductrice 8 non recouverte de résine. Cette gravure peut être réalisée par attaque chimique sélective en utilisant par exemple une solution de $H_3PO_4$-$H_2O_2$-$H_2O$ (6/3/100).

Après gravure de la couche 8, suivie de l'élimination de la couche de résine 52, on effectue le dépôt de la grille du transistor par exemple par la technique de lift-off. A cet effet, comme représenté sur la figure 10, on dépose sur l'ensemble de la structure une couche de résine 56 notamment positive, et on forme dans cette couche, par les procédés classiques de photolithographie, une ouverture 58 d'environ 1 $\mu$m de large. Cette ouverture 58 définit les dimensions de la grille du transistor à réaliser. On recouvre ensuite la couche de résine 56 d'un dépôt métallique 60 formé par exemple de trois couches superposées respectivement en titane, platine et or. L'emploi de trois couches superposées permet la réalisation d'un bon contact Schottky. Ce dépôt métallique 60 présente une épaisseur d'environ 200 nm. On dissout ensuite le masque de résine 56 avec de l'acétone. La structure finale est représentée en perspective sur la figure 11.

Sur cette figure, le laser à jonction PN 36, 28 porte la référence 62. Pour symboliser son fonctionnement, par injection transverse des électrons, on a représenté une flèche f dans la zone active 37 du laser. Sur la figure 11, le transistor à effet de champ comportant la source 26, le drain 28 et la grille 59 portent la référence générale 64.

Chose remarquable de cette structure monolithique, la région N 28 sert à la fois de région N pour la jonction PN du laser ainsi que de drain pour le transistor à effet de champ. De même, le contact ohmique 48 sert à la fois d'électrode pour le laser ei de contacts ohmiques pour le drain du transistor.

En outre, les électrodes 50 et 48 du laser s'étendent d'un côté opposé à l'autre de la structure.

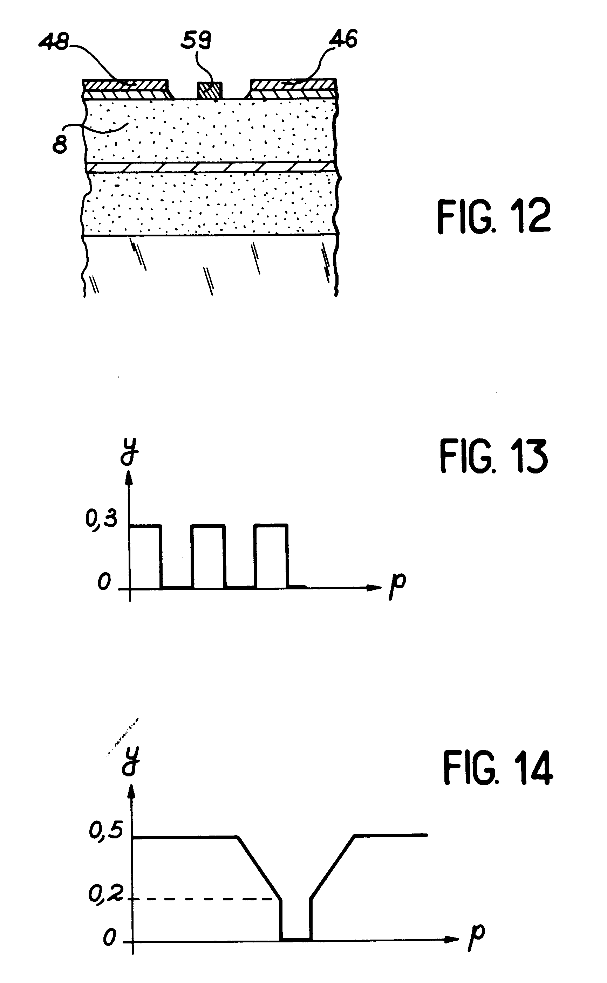

La description précédente se référait à une structure monolithique dans laquelle la grille 59 du transistor était enterrée. Toutefois, il est possible, comme représenté sur la figure 13, de réaliser la grille du transistor sans graver au préalable la couche semi-conductrice 8.

La structure monolithique selon l'invention, décrite précédemment comportait une couche active semi-conductrice 6 réalisée en $Ga_{1-y}Al_yAs$ dopé N, dans laquelle y gardait une valeur constante sur toute l'épaisseur de la couche. La couche active 6 était classique. En particulier, y, communément appelé composition, était égal à 0,08. Toutefois, afin d'améliorer le confinement latéral des électrons, notamment entre les régions P 36 et N 28 du laser, et donc d'augmenter l'intensité lumineuse de la lumière émise dans la couche 6 et par suite le courant de seuil du laser, il est possible de réaliser la couche semi-conductrice 6 sous forme quantique, c'est-à-dire en un matériau dont la composition y varie dans l'épaisseur de la couche. Cette variation y en fonction de la profondeur p de la couche peut présenter la forme d'une fonction alternative rectangulaire, comme représenté sur la figure 13, ou bien la forme d'un entonnoir, comme représenté sur la figure 14.

Les variations de la composition y de la couche semi-conductrice 6, telle que représentée sur la figure 13, peuvent être réalisées en déposant alternativement deux couches de compositions différentes, par exemple $y = 0$ et $y = 0,3$, alternées, ces deux couches distinctes présentant une épaisseur identique, par exemple de l'ordre de 10 nm. Les couches de composition $y = 0$ sont de préférence non dopées et les couches de composition $y = 0,3$ de préférence dopées N.

La couche semi-conductrice quantique peut présenter une épaisseur totale égale à 70 nm. Cette couche semi-conductrice, du type super-réseau, symbolysant une succession de barrières de potentiel et de puits de potentiel pour les électrons (Multi-quantum Well en terminologie anglosaxonne), permet non seulement d'améliorer les propriétés émettrices du laser mais aussi celles de fonctionnement du transistor à effet de champ. En particulier la vitesse de fonctionnement est augmentée ; ceci est dû à une mobilité accrue des porteurs confinés dans un puits de potentiel à deux dimensions.

L'une des raisons de l'amelioration des propriétés émettrices du laser est due à la formation d'un désordre d'alliage sélectif dans les régions P et N, lors de la diffusion ou de l'implantation ionique, entraînant la formation d'une hétérojonction dans le plan de front de diffusion ou d'implantation.

La couche active 6 de la structure selon l'invention, dont la composition y varie progressivement en fonction de la profondeur p de cette couche, comme représenté sur la figure 14, est connue sous l'abréviation de GRINSCH.

La description donnée précédemment n'a bien entendu été donnée qu'à titre d'exemple illustratif, toutes modifications, sans pour autant sortir du cadre de l'invention, pouvant être envisagées. En particulier, l'épaisseur, le dopage et la composition des différentes couches semi-conductrices de la structure laser-transistor à effet de champ selon l'invention peuvent être modifiés.

**Revendications**

1. Structure semi-conductrice monolithique d'un laser (62) et d'un transistor à effet de champ (64) comportant une source (26), un drain (28) et une grille (59), la structure étant réalisée sur un substrat semi-isolant monocristallin (2), la structure comprenant:
une première (4), une seconde (6) et une troisième (8) couches semi-conductrices superposées dans cet ordre, la première et la troisième couches étant non dopées et la seconde couche (6) présentant une bande interdite inférieure aux bandes interdites de la première (4) et de la troisième (8) couches et constituant la couche active du laser (62) et le canal (27) du transistor (64), une première région (36) d'un premier type de conductivité, une seconde (28) et une troisième (26) régions d'un second type de conductivité, formées dans les première (4), seconde (6) et troisième (8) couches semi-conductrices et orientées perpendiculairement à ces couches, la première (36) et la seconde (28) régions délimitant entre elles la zone active (37) du laser, la seconde (28) et la troisième (26) régions, formant respectivement le drain (28) et la source (26) du transistor, délimitant entre elles le canal (27) dudit transistor.

2. Structure semi-conductrice selon la revendication 1, caractérisée en ce que le laser (62) comprend des électrodes métalliques (48, 50) situées dans un plan parallèle aux couches semi-conductrices (4, 6, 8), la source (26) et le drain (28) du transistor (64) étant pourvus de contacts ohmiques (46, 48) situés dans ce plan.

3. Structure semi-conductrice selon la revendication 1 ou 2, caractérisée en ce que la troisième couche semi-conductrice (8) est recouverte en partie d'une quatrième couche semi-conductrice (10) servant de couche de contact électrique pour le laser (62) et pour le transistor (64), cette quatrième couche (10) présentant une bande interdite inférieure à celle des première (4) et troisième (8) couches.

4. Structure semi-conductrice selon l'une quelconque des revendications 1 à 3, caractérisée en ce que la première (4), la seconde (6) et la troisième (8) couches semi-conductrices sont réalisées respectivement en $Ga_{1-x}Al_xAs$ non dopé, $6a_{1-x}Al_xAs$ dopé N et $Ga_{1-z}Al_zAs$ non dopé, avec $0 < x \leq 1$, $0 \leq y < 1$ et $0 < z \leq 1$, x et z étant supérieurs à y.

5. Structure semi-conductrice selon la revendication 4, caractérisée en ce que x et z sont pris dans l'intervalle allant de 0,2 à 0,7 et y est pris dans l'intervalle allant de 0 à 0,15.

6. Structure semi-conductrice selon la revendication 3, caractérisée en ce que la quatrième couche semi-conductrice (10) est réalisée en GaAs non dopé.

7. Structure semi-conductrice selon l'une quelconque des revendications 1 à 6, caractérisée en ce que le substrat (2) est réalisé en GaAs.

8. Structure semi-conductrice selon la revendication 1, caractérisée en ce qu'elle comprend sur un substrat (2) en GaAs :

- une première couche semi-conductrice (4) en $Ga_{1-x}Al_xAs$ non dopé, avec $0,2 \leq x \leq 0,7$, recouverte d'une seconde couche semi-conductrice (6) en $Ga_{1-y}Al_yAs$ dopé M, avec $0 \leq y \leq 0,15$, formant la coucha active du laser (62) et le canal (27) du transistor (64),
- une troisième couche semi-conductrice (8) en $Ga_{1-z}Al_zAs$ non dopé, avec $0,2 \leq z \leq 0,7$ recouvrant la seconde couche (6),
- une quatrième couche semi-conductrice (10) en GaAs non dopé recouvrant la troisième couche (8),
- une première région de type P (36), une seconde (28) et une troisième (26) régions de type N, formées dans les première (4), seconde (6), troisième (8) et quatrième (10) couches et orientées perpendiculairement à ces couche, la première (36) et la seconde (28) régions délimitant entre elles la zone active du laser, la seconde (28) et la troisième (26) régions, formant respectivement le drain (28) et la source (26) du transistor, délimitant entre elles le canal (27) du transistor,
- une électrode (50) en AuZn recouvrant la région de type P (36),
- un contact ohmique (48, 46) en AuGeNi recouvrant chacune des régions de type N (28, 26), et
- une grille (59) en TiPtAu surmontant le canal (27) du transistor.

9. Structure semi-conductrice selon l'une quelconque des revendications 1 à 8, caractérisée en ce que la seconde couche semi-conductrice (6) est un superréseau formé de deux séries de couches minces semi-conductrices de composition différente alternées.

10. Structure semi-conductrice selon l'une quelconque des revendications 1 à 8, caractérisée en ce que la seconde couche semi-conductrice (6) est une couche dont la composition varie progressivement dans l'épaisseur de la couche.

11. Structure semi-conductrice selon l'une quelconque des revendications 2 à 10, caractérisée en ce que la grille (59) du transistor est située à un niveau inférieur à celui des contacts ohmiques (46, 48) de la source et du drain du transistor.

12. Procédé de fabrication sur un substrat semi-isolant monocristallin (2), d'une structure semi-conductrice monolithique d'un laser (62) et d'un transistor à effet de champ (64), comportant les étapes suivantes :

- épitaxier sur le substrat, dans l'ordre, une première (4), une seconde (6) et une troisième (8) couches semi-conductrices, la première et la troisième couches étant non dopées, la seconde (6) couche présentant une bande interdite inférieure aux bandes interdites de la première (4) et de la troisième (8) couches et constituant la couche active du laser (62) et le canal (27) du transistor,
- introduire des ions dans les couches semi-conductrices (4, 6, 8) pour y former une première région (36) d'un premier type de conductivité, une seconde (28) et une troisième (26) régions d'un second type de conductivité, orientées perpendiculairement aux plans des couches semi-conductrices, la première (36) et la seconde (28) régions délimitant entre elles la zone active (37) du laser, la seconde (28) et la troisième (26) régions formant respectivement le drain et la source du transistor, délimitant entre elles le canal (27) du transistor, et
- former les électrodes (50) du laser, les contacts ohmiques (46, 48) de la source et du drain du transistor ainsi que la grille (59) du transistor.

13. Procédé de fabrication selon la revendication 12, caractérisé en ce que l'on dépose par épitaxie, sur la troisième couche (8), une quatrième couche (10) semi-conductrice pour former les contacts des électrodes du laser, de la source et du drain du transistor, cette quatrième couche (10) présentant une bande interdite inférieure à celle des première (4) et troisième (8) couches semi-conductrices.

14. Procédé de fabrication selon la revendication 12 ou 13, caractérisé en ce que l'on forme la grille (59) du transistor après gravure partielle de la zone de la troisième couche (8) présente entre les seconde (28) et troisième (26) régions.

**Claims**

1. Monolithic semiconductor structure of a laser (62) and a field effect transistor (64) having a source (26), a drain (28) and a gate (59), the structure being produced on a monocrystalline semiinsulating substrate (2), the structure comprising first (4), a second (6) and a third (8) semiconductor layer superimposed in this order, the first and third layers not being doped and the second layer (6) having a forbidden band below the forbidden bands of the first (4) and third (8) layers, constituting the active layer of the laser (62) and the channel (27) of the transistor (64), a first region (36) of a first conductivity type, a second (28) and a third (26) region of a second conductivity type formed in the first (4), second (6) and third (8) semiconductor layers and oriented perpendicularly to these layers, the first (36) and second (28) regions defining between them the active zone (37) of the laser, the second (28) and third (26) regions respectively forming the transistor drain (28) and source (26) and defining between them the channel (27) of said transistor

2. Semiconductor structure according to claim 1, characterized in that the laser (62) comprises metal electrodes (48,50) located in a plane parallel to the semiconductor layers (4,6,8) the source (26) and drain (28) of the transistor (64) having ohmic contacts (46,48) located in this plane.

3. Semiconductor structure according to claim 1 or 2, characterized in that the third semiconductor layer (8) is partly covered with a fourth semiconductor layer (10) serving as an electric contact layer for the laser (62) and the transistor (64), said fourth layer (10) having a forbidden band below that of the first (4) and third (8) layers.

4. Semiconductor structure according to any one of the claims 1 to 3, characterized in that the first (4), second (6) and third (8) semiconductor layers are respectively produced from undoped $Ga_{1-x}Al_xAs$, N-doped $Ga_{1-y}Al_yAs$ and undoped $Ga_{1-z}Al_zAs$ with $0 < x \leq 1$, $0 \leq y < 1$ and $0 < z \leq 1$, x and z being greater than y.

5. Semiconductor structure according to claim 4, characterized in that x and z are taken in the range 0.2 to 0.7 and y in the range 0 to 0.15.

6. Semiconductor structure according to claim 3, characterized in that the fourth semiconductor layer (10) is of undoped GaAs.

7. Semiconductor structure according to any one of the claims 1 to 6, characterized in that the substrate (2) is of GaAs.

8. Semiconductor structure according to claim 1, characterized in that it comprises on a GaAs substrate (2):
a first undoped $Ga_{1-x}Al_xAs$ semiconductor layer (4) with 0.2 x 0.7, covered with a second N-doped $Ga_{1-y}Al_yAs$ semiconductor layer (6) with $0 \leq y \leq 0.15$, forming the active layer of the laser (62) and the channel (27) of the transistor (64),
a third undoped $Ga_{1-z}Al_zAs$ semiconductor layer (8) with $0.2 \leq z \leq 0.7$ covering the second layer (6),
a fourth undoped GaAs semiconductor layer (10) covering the third layer (8),
a first type P region (36), a second (28) and a third (26) type N regions, oriented perpendicularly to the planes of the first (4), second (6) third (8) and fourth (10) layers, the first (26) and second (28) regions defining between them the active zone of the laser, the second (28) and third (26) regions respectively forming the drain (28) and source (26) of the transistor, defining between them the transistor channel (27), a Au-Zn electrode (50) covering the type P region (36)
a AuGeNi ohmic contact (48,46) covering each of the N type regions (28,26), and
a TiPtAu gate (59) surmounting the transistor channel (27).

9. Semiconductor structure according to any one of the claims 1 to 8, characterized in that the second semiconductor layer (6) is a superlattice formed from two alternate series of semiconductor films of different composition.

10. Semiconductor structure according to any one of the claims 1 to 9, characterized in that the second semiconductor layer (6) has a composition which varies progressively in the thickness of the layer.

11. Semiconductor structure according to any one of the claims 2 to 10, characterized in that the transistor gate (59) is located at a level below that of the ohmic contacts (46,48) of the transistor source and drain.

12. Process for the production on a monocrystalline semiinsulating substrate (2) of a monolithic semiconductor structure of a laser (62) and field effect transistor (64), comprising the following stages:
epitaxying on the substrate, in order, a first (4), a second (6) and a third (8) semiconductor layers, the second (6) layer having a forbidden band below the forbidden bands of the first (4) and third (8) layers, constituting the active layer of the laser (62) and the channel (27) of the transistor,

introducing ions into the semiconductor layers (4,6,8) for forming a first region (36) of a first conductivity type, a second (28) and a third (26) regions of a second conductivity type, which are oriented perpendicularly to the planes of the semiconductor layers, the first (36) and second (28) regions defining between them the active zone (37) of the laser, the second (28) and third (26) regions respectively forming the transistor drain and source, defining between them the transistor channel (27), and

forming the electrodes (50) of the laser, the ohmic contacts (46, 48) of the source and the drain of the transistor, as well as the gate (59) of the transistor.

13. Production process according to claim 12, characterized in that on the third layer (8) is deposited by epitaxy a fourth semiconductor layer (10) for forming the contacts of the electrodes of the laser, the source and drain of the transistor, said fourth layer (10) having a forbidden band below that of the first (4) and third (8) semiconductor layers.

14. Production process according to claims 12 or 13, characterized in that the transistor gate (59) is formed after partial etching of the zone of the third layer (8) between the second (28) and third (26) regions.

**Patentansprüche**

1. Monolithische Halbleiterstruktur aus einem Laser (62) und einem Feldeffekttransistor (64), eine Source (26), einen Drain (28) und ein Gate (59) enthaltend und in einem halbleitenden monokristallinen Substrat (2) ausgebildet, bestehend aus: einer ersten (4), einer zweiten (6) und einer dritten (8) in dieser Reihenfolge übereinander angeordneten Halbleiterschicht, wobei die erste und die dritte Schicht nicht dotiert sind und die zweite Schicht (6) ein verbotenes Band aufweist, das niedriger ist, als die verbotenen Bänder der ersten (4) und der dritten (8) Schicht und die die aktive Schicht des Lasers (62) und den leitfähigen Kanal (27) des Transistors (64) darstellt, einer ersten Zone (36) einer ersten Leitungsart, einer zweiten (28) und einer dritten (26) Zone einer zweiten Leitungsart, ausgebildet in der ersten (4), zweiten (6) und dritten (8) Halbleiterschicht und senkrecht zu diesen Schichten verlaufend, wobei die erste (36) und die zweite (28) Zone zwischen sich das aktive Gebiet (37) des Lasers einschließen, die zweite (28) und die dritte (26) Zone den Drain (28) bzw. die Source (26) des Transistors bilden und zwischen sich den Kanal (27) des genannten Transistors einschließen.

2. Halbleiterstruktur gemäß Patentanspruch 1, dadurch gekennzeichnet, daß der Laser (62) Metallelektroden (48, 50) enthält, die in einer Ebene parallel zu den Halbleiterschichten (4, 6, 8) angeordnet sind, wobei die Source (26) und der Drain (28) des Transistors (64) mit in dieser Ebene angeordneten ohmschen Kontakten (46, 48) versehen sind.

3. Halbleiterstruktur gemäß Patentanspruch 1 oder 2, dadurch gekennzeichnet, daß die dritte Halbleiterschicht (8) teilweise mit einer vierten Halbleiterschicht (10) bedeckt ist, die als elektrische Kontaktschicht für den Laser (62) und für den Transistor (64) dient, wobei diese vierte Schicht (10) ein verbotenes Band aufweist, das niedriger ist, als das der ersten (4) und dritten Schicht (8).

4. Halbleiterstruktur gemäß irgendeinem der Patentansprüche 1 bis 3, dadurch gekennzeichnet, daß die erste (4), die zweite (6) und die dritte Halbleiterschicht (8) aus nicht dotiertem $Ga_{1-x}Al_xAs$, aus dotiertem $Ga_{1-y}Al_yAs$ bzw. aus nicht dotiertem $Ga_{1-z}Al_zAs$ bestehen, wobei $0 < x \leq 1$, $0 \leq y < 1$ und $0 < z \leq 1$ und $x$ und $z$ größer als $y$ sind.

5. Halbleiterstruktur gemäß Patentanspruch 4, dadurch gekennzeichnet, daß $x$ und $z$ aus dem Bereich zwischen 0,2 und 0,7 und $y$ aus dem Bereich zwischen 0 und 0,15 gewählt werden.

6. Halbleiterstruktur gemäß Patentanspruch 3, dadurch gekennzeichnet, daß die vierte Halbleiterschicht (10) aus nicht dotiertem GaAs besteht.

7. Halbleiterstruktur gemäß irgendeinem der Patentansprüche 1 bis 6, dadurch gekennzeichnet, daß das Substrat (2) aus GaAs besteht.

8. Halbleiterstruktur gemäß Patentanspruch 1, dadurch gekennzeichnet, daß sie auf einem Substrat (2) aus GaAs besteht aus:
   - einer ersten Halbleiterschicht (4) aus nicht dotiertem $Ga_{1-x}Al_xAs$ mit $0,2 \leq x \leq 0,7$, beschichtet mit einer zweiten Halbleiterschicht (6) aus N-dotiertem $Ga_{1-y}Al_yAs$ mit $0 \leq Y \leq 0,15$, die die aktive Schicht des Lasers (62) und den Kanal (27) des Transistors (64) bildet,

- einer dritten Halbleiterschicht (8) aus nicht dotiertem $Ga_{1-z}Al_zAs$ mit $0,2 \leq z \leq 0,7$, die die zweite Schicht (6) bedeckt,
- einer vierten Halbleiterschicht (10) aus nicht dotiertem GaAs, die die dritte Schicht (8) bedeckt,
- einer ersten dotierten Zone (36), einer zweiten (28) und einer dritten (26) n-dotierten Zone, die in der ersten (4), der zweiten (6), der dritten (8) und der vierten Schicht (10) ausgebildet und senkrecht zu diesen Schichten angeordnet sind, wobei die erste (36) und die zweite Zone (28) zwischen sich das aktive Gebiet des Lasers einschließen, die zweite (28) und die dritte Zone (26), die den Drain (28) bzw. die Source (26) des Transistors bilden, zwischen sich den Kanal (27) des Transistors einschließen,
- einer Elektrode (50) aus AuZn, die die p-Zone (36) bedeckt,
- einem ohmschen Kontakt (48, 46) aus AuGeNi, der jede der n-dotierten Zonen (28, 26) bedeckt, und
- einem Gate (59) aus TiPtAu, der sich auf dem Kanal (27) des Transistors befindet.

9. Halbleiterstruktur gemäß irgendeinem der Patentansprüche 1 bis 8, dadurch gekennzeichnet, däß die zweite Halbleiterschicht (6) ein aus zwei Folgen einander abwechselnder dünner Halbleiterschichten unterschiedlicher Zusammensetzung bestehendes "Übergitter" ist.

10. Halbleiterstruktur gemäß irgendeinem der Patentansprüche 1 bis 8, dadurch gekennzeichnet, daß die zweite Halbleiterschicht (6) eine Schicht ist, deren Zusammensetzung sich fortschreitend über die Dicke der Schicht verändert.

11. Halbleiterstruktur gemäß irgendeinem der Patentansprüche 2 bis 10, dadurch gekennzeichnet, daß sich das Gate (59) des Transistors auf einer geringeren Höhe befindet, als die ohmschen Kontakte (46, 48) der Source und des Drain des Transistors.

12. Verfahren zur Herstellung einer monolithischen Halbleiterstruktur aus einem Laser (62) und einem Feldeffekttransistor (64) auf einem halbleitenden monokristallinen Substrat (2), bestehend aus folgenden Schritten:
- epitaktisches Aufwachsen einer ersten (4), einer zweiten (6) und einer dritten Halbleiterschicht (8) in dieser Reihenfolge auf das Substrat, wobei die erste und die dritte Schicht nicht dotiert sind und die zweite Schicht (6) ein verbotenes Band aufweist, das niedriger ist, als die verbotenen Bänder der ersten (4) und der dritten (8) Schicht und die die tive Schicht des Lasers (62) und den Kanal (27) des Transistors (64) darstellt,
- Einführen von Ionen in die Halbleiterschichten (4, 6, 8), um dort eine erste Zone (36) einer ersten Leitungsart, eine zweite (28) und eine dritte (26) Zone einer zweiten Leitungsart senkrecht zu den Ebenen der Halbleiterschichten verlaufend auszubilden, wobei die erste (36) und die zweite (28) Zone zwischen sich das aktive Gebiet (37) des Lasers einschließen, die zweite (28) und die dritte (26) Zone den Drain bzw. die Source des Transistors bilden und zwischen sich den Kanal (27) des genannten Transistors einschließen, und
- Ausbilden der Elektroden (50) des Lasers, der ohmschen Kontakte (46, 48) der Source und des Drain des Transistors, sowie des Gate (59) des Transistors.

13. Herstellungsverfahren gemäß Patentanspruch 12, dadurch gekennzeichnet, daß auf die dritte Schicht (8) durch Epitaxie eine vierte Halbleiterschicht (10) aufgebracht wird, um die Kontakte der Elektroden des Lasers, der Source und des Drain des Transistors auszubilden, wobei diese vierte Schicht (10) ein verbotenes Band aufweist, das niedriger ist, als das der ersten (4) und das der dritten Halbleiterschicht (8).

14. Herstellungsverfahren gemäß Patentanspruch 12 oder 13, dadurch gekennzeichnet, däß man das Gate (59) des Transistors nach partieller Gravur des zwischen der zweiten (28) und der dritten Zone (26) liegenden Bereichs der dritten Schicht (8) ausbildet.

FIG. 1

FIG. 2

FIG. 3

FIG. 4

FIG. 5

FIG. 6

FIG. 7

FIG. 8

FIG. 9

FIG. 10

FIG. 11

EP 0 232 662 B1

FIG. 12

FIG. 13

FIG. 14